# EUROPEAN PATENT APPLICATION

(11) **EP 4 625 483 A2**
(43) Date of publication of application: **01.10.2025**
(21) Application number: 25163970.4
(22) Date of filing: 14.03.2025
(51) Int. Cl.: H01L 21/768, H01L 23/528, H10D 30/00, H10D 62/00, H10D 84/00

(54) **CONDUCTIVE VIA THROUGH A FIN ISOLATION STRUCTURE BETWEEN SEMICONDUCTOR DEVICES**

(30) Priority: 26.03.2024 US 202418616857
(71) Applicant: INTEL Corporation, Santa Clara, CA 95054 (US)
(72) Inventor: BOUCHE, Guillaume, Portland, 97211 (US); JUN, Hwichan, Portland, 97229 (US)
(74) Representative: 2SPL Patentanwälte PartG mbB

(57) **Abstract**

Techniques are provided herein to form an integrated circuit having a conductive via extending through a fin isolation structure. Transistors each include semiconductor material extending colinearly in a first direction between source and drain regions, and gate structures extending in a second direction around the semiconductor material of each transistor. A fin isolation structure may extend along the second direction between the transistor s to provide electrical isolation between the transistors. The fin isolation structure may include one or more dielectric materials that are deposited within a trench extending between the transistors. A conductive via extends through the core of the fin isolation structure to provide electrical connection between frontside features and backside features of the integrated circuit. **In** this way, the conductive via shares the same location as the fin isolation structure which provides efficient use of the limited space on a given die.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. As transistors are packed more densely, the formation of certain device structures, such as via structures, becomes more challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of different semiconductor devices in an integrated circuit that includes a conductive via through a fin isolation structure, in accordance with an embodiment of the present disclosure.
Figures 2A and 2B are cross-sectional and plan views, respectively, that illustrate one stage in an example process for forming an integrated circuit configured with a conductive via through a fin isolation structure, in accordance with an embodiment of the present disclosure.
Figures 3A and 3B are cross-sectional and plan views, respectively, that illustrate another stage in the example process for forming an integrated circuit configured with a conductive via through a fin isolation structure, in accordance with an embodiment of the present disclosure.
Figures 4A and 4B are cross-sectional and plan views, respectively, that illustrate another stage in the example process for forming an integrated circuit configured with a conductive via through a fin isolation structure, in accordance with an embodiment of the present disclosure.
Figures 5A and 5B are cross-sectional and plan views, respectively, that illustrate another stage in the example process for forming an integrated circuit configured with a conductive via through a fin isolation structure, in accordance with an embodiment of the present disclosure.
Figures 6A and 6B are cross-sectional and plan views, respectively, that illustrate another stage in the example process for forming an integrated circuit configured with a conductive via through a fin isolation structure, in accordance with an embodiment of the present disclosure.
Figures 7A and 7B are cross-sectional and plan views, respectively, that illustrate another stage in the example process for forming an integrated circuit configured with a conductive via through a fin isolation structure, in accordance with an embodiment of the present disclosure.
Figures 8A and 8B are cross-sectional and plan views, respectively, that illustrate another stage in the example process for forming an integrated circuit configured with a conductive via through a fin isolation structure, in accordance with an embodiment of the present disclosure.
Figures 9A and 9B are cross-sectional and plan views, respectively, that illustrate another stage in the example process for forming an integrated circuit configured with a conductive via through a fin isolation structure, in accordance with an embodiment of the present disclosure.
Figures 10A and 10B are cross-sectional and plan views, respectively, that illustrate another stage in the example process for forming an integrated circuit configured with a conductive via through a fin isolation structure, in accordance with an embodiment of the present disclosure.
Figures 11A and 11B are cross-sectional and plan views, respectively, that illustrate another stage in the example process for forming an integrated circuit configured with a conductive via through a fin isolation structure, in accordance with an embodiment of the present disclosure.
Figures 12A and 12B are cross-sectional and plan views, respectively, that illustrate another stage in the example process for forming an integrated circuit configured with a conductive via through a fin isolation structure, in accordance with an embodiment of the present disclosure.
Figures 13A and 13B are cross-sectional and plan views, respectively, that illustrate another stage in the example process for forming an integrated circuit configured with a conductive via through a fin isolation structure, in accordance with an embodiment of the present disclosure.
Figures 14A and 14B are cross-sectional and plan views, respectively, that illustrate another stage in the example process for forming an integrated circuit configured with a conductive via through a fin isolation structure, in accordance with an embodiment of the present disclosure.
Figures 15A and 15B are cross-sectional and plan views, respectively, that illustrate another stage in the example process for forming an integrated circuit configured with a conductive via through a fin isolation structure, in accordance with an embodiment of the present disclosure.
Figures 16A and 16B are cross-sectional and plan views, respectively, that illustrate another stage in the example process for forming an integrated circuit configured with a conductive via through a fin isolation structure, in accordance with an embodiment of the present disclosure.
Figure 17 is a cross-section view of the integrated circuit from Figure 16A with a backside contact made to the conductive via, in accordance with an embodiment of the present disclosure.
Figure 18 illustrates a cross-sectional view of a chip package containing one or more semiconductor dies, in accordance with some embodiments of the present disclosure.
Figure 19 is a flowchart of a fabrication process for semiconductor devices having a conductive via through a fin isolation structure, in accordance with an embodiment of the present disclosure.
Figure 20 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having a conductive via extending through a fin isolation structure. The techniques can be used in any number of integrated circuit applications and are particularly useful with respect to logic and memory cells, such as those cells that use finFETs or gate-all-around transistors (e.g., ribbonFETs and nanowire FETs) or forksheet transistors. In one such example, FETs (field effect transistors) each includes semiconductor material extending colinearly in a first direction between source and drain regions, and gate structures extending in a second direction around the semiconductor material of each FET. The semiconductor material of each FET may be a fin or any number of nanowires (or nanoribbons or nanosheets, as the case may be). A fin isolation structure may extend along the second direction between the FETs to provide electrical isolation between the FETs. The fin isolation structure may include one or more dielectric materials that are deposited within a trench extending between the FETs. According to some embodiments, a conductive via extends through the core of the fin isolation structure to provide electrical connection between frontside features and backside features of the integrated circuit. In this way, the conductive via shares the same location as the fin isolation structure which provides efficient use of the limited space on a given die. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Example structures like vias that pass through the device layer may be used in integrated circuit design for power and signal routing to backside connections. Other example structures include fin isolation structures that electrically isolate different portions of a semiconductor fin (e.g., isolating devices formed from the fin on either side of the fin isolation structure). Since several devices can be formed along the length of a single fin, fin isolation structures can be used to isolate any devices along the fin. There is often very limited space on a given die to form the aforementioned via structures and fin isolation structures, and this problem is only becoming more difficult as devices continue to scale smaller and pack more densely on the chip.

Thus, and in accordance with an embodiment of the present disclosure, techniques are provided herein to form conductive vias through fin isolation structures. By combining vias and fin isolation structures in the same location on the chip, additional space may be freed up elsewhere for more efficient device packing or for other patterned features. In some embodiments, a fin isolation structure is formed by first forming an opening between semiconductor devices. The opening may be a trench-like opening that cuts across the height of a fin (or the semiconductor material from the fin) in order to isolate semiconductor devices on either side of the opening. According to some embodiments, a dielectric liner is subsequently formed within the opening to cover at least the sidewalls of the opening. A conductive material may be formed on the dielectric liner within the opening to form the via that extends along a third direction (e.g., vertical direction) between a frontside of the device layer and a backside of the device layer. In some embodiments, the via may be wider along the first direction compared to the gate structures around the semiconductor regions of the adjacent devices. In some examples, the via is at least 1.5 times, at least 2 times, at least 2.5 times, or at least 3 times wider than the width of the adjacent gate structures along the first direction. Additionally, the via may extend lower than the bottom surface of the gate structures in order to contact any number of backside contacts.

According to an embodiment, an integrated circuit includes a semiconductor region extending in a first direction from a first side of a source or drain region, a gate structure extending in a second direction over the semiconductor region with the second direction being different than the first direction, a dielectric layer beneath the gate electrode, and a conductive via extending in the second direction adjacent to a second side of the source or drain region opposite from the first side and extending in a third direction below a top surface of the dielectric layer. The gate structure has a first width along the first direction at a top surface of the gate electrode and the conductive via has a second width along the first direction at a top surface of the conductive via. The second width is larger than the first width.

According to another embodiment, an electronic device includes a chip package having one or more dies. At least one of the one or more dies includes a first semiconductor region extending in a first direction from a first side of a source or drain region, a second semiconductor region extending in the first direction from a second side of the source or drain region, a gate structure extending in a second direction over the first semiconductor region with the second direction being different than the first direction, a dielectric layer beneath the gate electrode, and a conductive via extending in the second direction adjacent to the second semiconductor region and extending in a third direction below a top surface of the dielectric layer. The second semiconductor region is between the source or drain region and the conductive via along the first direction.

According to another embodiment, an integrated circuit includes a semiconductor region extending in a first direction from a source or drain region, a gate structure extending in a second direction over the semiconductor region with the second direction being different than the first direction, a conductive via extending in the second direction adjacent to a second side of the source or drain region opposite from the first side and extending in a third direction below a bottom surface of the gate structure, a first dielectric gate cut extending lengthwise along the first direction, and a second dielectric gate cut extending lengthwise along the first direction. The conductive via extends along the second direction between the first dielectric gate cut and the second dielectric gate cut.

According to an embodiment, a method of forming an integrated circuit includes forming a first fin having first semiconductor material extending in a first direction at a first length and a second fin having second semiconductor material extending colinearly with the first fin in the first direction at a second length longer than the first length with each of the first and second fins extending above a substrate; forming a source or drain region between the first fin and the second fin such that the source or drain region contacts ends of the first semiconductor material and ends of the second semiconductor material; forming a first gate structure extending over the first semiconductor material in a second direction different from the first direction; forming a second gate structure extending over the second semiconductor material in a second direction different from the first direction; forming a recess through at least an entire height of the second gate structure, and through the second semiconductor material; forming a dielectric liner on surfaces within the recess; and forming a conductive via within a remaining portion of the recess.

The techniques can be used with any type of planar or non-planar transistors, including finFETs (sometimes called double-gate transistors, or tri-gate transistors), or nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of one or more conductive vias extending through an entire height of the device layer and also extending lengthwise along the same direction as the lengthwise direction of the transistor gate structures (e.g., cutting across one or fins to also act as a fin isolation structure). A dielectric liner may be visible along the sidewalls of the conductive vias to electrically isolate the conductive vias from any adjacent elements in the device layer. The conductive via may be observed as being wider than the transistor gate structures (e.g., at least twice as wide). In some embodiments, the conductive via extends below a bottom surface of the adjacent transistor gate structures (or below a top surface of a dielectric layer beneath the transistor gate structures).

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

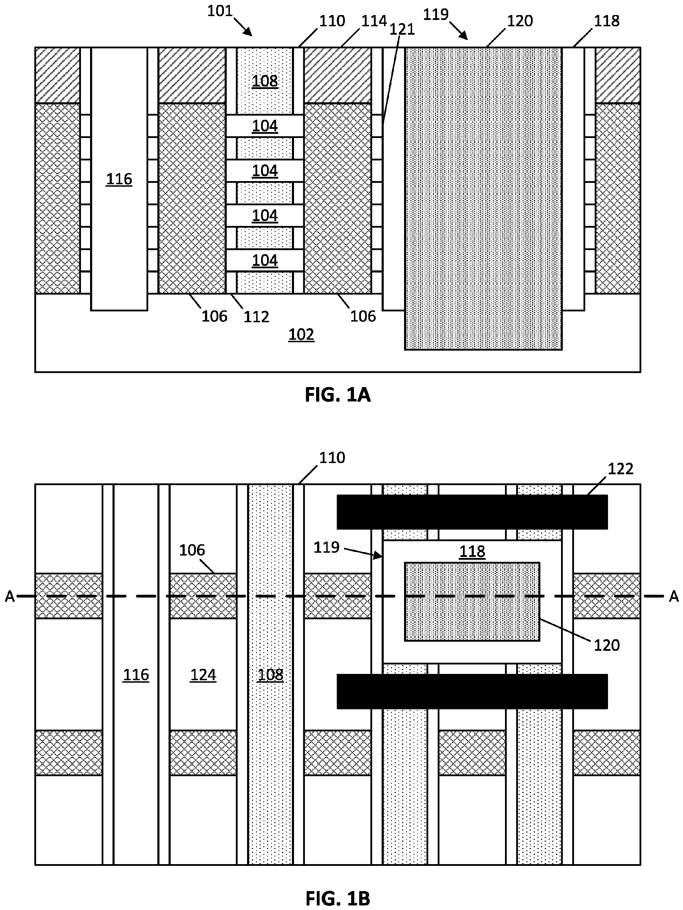

Figure 1A is a cross-section view taken along a 'fin' direction that illustrates semiconductor bodies extending between source or drain regions, in accordance with an embodiment of the present disclosure. Figure 1B illustrates a plan view across a portion of the integrated circuit. The cross-section of Figure 1A is taken across the dashed line A-A illustrated in the plan view of Figure 1B. Any number of semiconductor devices maybe formed along the fin. Figure 1A illustrates one semiconductor device 101 and fin isolation structures on different sides of semiconductor device 101. Semiconductor device 101 may be, for instance, a non-planar metal oxide semiconductor (MOS) transistor, such as tri-gate (e.g., finFET) or gate-all-around (GAA) transistor, although other transistor topologies and types could also benefit from the techniques provided herein. The examples herein illustrate semiconductor devices with a GAA structure (e.g., having nanoribbons, nanowires, or nanosheets that extend between source and drain regions). Other examples may have a forksheet structure having a p-type device and an n-type device separated by a dielectric spine or structure.

The semiconductor material used in each of the semiconductor devices may be formed from or on a semiconductor substrate. According to some embodiments, the substrate is removed following the completion of all frontside processing and is replaced with a base dielectric structure 102. Base dielectric structure 102 may represent any number of dielectric layers and/or materials. In some examples, base dielectric structure 102 includes one or more layers of silicon dioxide.

The one or more semiconductor regions of the devices may include fins that can be, for example, native to the substrate (formed from the substrate itself), such as silicon fins etched from a bulk silicon substrate. Alternatively, the fins can be formed of material deposited onto the substrate. In one such example case, a blanket layer of SiGe can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. Again, the alternating layers can be blanket deposited and then etched into fins or deposited into fin-shaped trenches, in some examples.

Semiconductor device 101 includes one or more semiconductor regions (also called channel regions), such as one or more nanoribbons 104 extending between epitaxial source or drain regions 106 in the first direction. A gate structure 108 extends over nanoribbons 104 of semiconductor device 101 in a second direction (e.g., into and out of the page) to form the transistor gate of semiconductor device 101.

Any of source or drain regions 106 may act as either a source region or a drain region, depending on the application and dopant profile. Any semiconductor materials suitable for source and drain regions can be used (e.g., group IV and group III-V semiconductor materials) for any of the illustrated source or drains regions 106a/106b. In any such cases, the composition and doping of source or drain regions 106a and 106b may be the same or different, depending on the polarity of the transistors. In an example, semiconductor device 101 is a p-channel device having a high concentration of p-type dopants in source or drain regions 106. In another example, semiconductor device 101 is an n-channel device having a high concentration of n-type dopants in source or drain regions 106. Example p-type dopants include boron and example n-type dopants include phosphorous or arsenic. Any number of source and drain configurations and materials can be used. In some examples, p-type source or drain regions include silicon germanium doped with boron and n-type source or drain regions include silicon doped with phosphorous.

The gate structure 108 may include a gate electrode that is made up of a conductive fill and one or more metal workfunction layers, according to some embodiments. Gate structure 108 may also include a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), or doped polysilicon. In some embodiments, semiconductor device 101 is a p-channel device having gate structure 108 with one or more workfunction layers of molybdenum nitride (MoN). Other metal workfunction layers of p-channel devices can include tantalum nitride (TaN) and titanium nitride (TiN). In some embodiments, semiconductor device 101 is an n-channel device having gate structure 108 with one or more workfunction layers of tungsten. Other metal workfunction layers of n-channel devices can include tantalum nitride (TaN).

The gate dielectric of gate structure 108 may include any suitable gate dielectric material(s). In some embodiments, the gate dielectric includes a layer of native oxide material (e.g., silicon dioxide germanium dioxide, or SiGe oxide) on nanoribbons 104, and a layer of high-k dielectric material (e.g., hafnium oxide or aluminum oxide) on the native oxide. According to some embodiments, spacer structures 110 and inner spacers 112 are present along the sidewalls of gate structure 108. Spacer structures 110 and inner spacers 112 may be any suitable dielectric material, such as silicon nitride, and provide separation between a given gate structure 108 and the adjacent source or drain regions 106. Inner spacers 112 may separate adjacent nanoribbons 104 from one another along a third direction (e.g., a vertical direction).

According to some embodiments, a dielectric fill 114 may be present over the source or drain regions 106 within the corresponding source/drain trenches of semiconductor device 101. A top surface of dielectric fill 114 may be substantially co-planar with a top surface of spacer structures 110. Dielectric fill 114 may include any suitable dielectric material, such as silicon dioxide, in some examples. In some embodiments, conductive contacts may be formed through dielectric fill 114 to contact the top surface of source or drain regions 106. The conductive contacts can include any suitable conductive material, such as tungsten, molybdenum, ruthenium, cobalt, or other metals. The conductive contacts may extend into source or drain regions 106 and/or wrap around portions of source or drain regions 106.

According to some embodiments, the integrated circuit includes one or more fin isolation structures 116 that cut across one or more fins to isolate devices on either side of the isolation structure. In the illustrated example, fin isolation structure 116 includes one or more dielectric materials that extend in the second direction within a gate trench to cut through any number of fins present within the gate trench (as shown in Figure 1B). Fin isolation structure 116 may include any suitable dielectric material, such as silicon nitride or any other high-k dielectric material. According to some embodiments, fin isolation structure 116 extends in the third direction along at least an entire height of the adjacent source or drain regions 106. A top surface of fin isolation structure 116 may be substantially coplanar with a top surface of spacer structures 110. In the example shown, fin isolation structure 116 extends into base dielectric structure 102, such that the bottom surface of fin isolation structure 116 is below a bottom surface of each of source and drain regions 106 and gate structure 108. The depth to which fin isolation structure 116 extends into dielectric structure 102 may be in the range of, for example, 0 nm to 25 nm. Other examples may be configured differently, such as the case where the bottom surfaces of source or drain regions 106 and gate structure 108 are not coplanar with one another.

According to some embodiments, the integrated circuit includes at least one larger fin isolation structure 119 (e.g., larger width along the first direction compared to fin isolation structure 116) that includes a via extending through a central portion of the larger fin isolation structure 119. Fin isolation structure 119 includes a dielectric layer or liner 118 and a conductive via 120 on dielectric liner 118. According to some such embodiments, dielectric liner 118 is between conductive via 120 and adjacent transistor structures, such as portions of semiconductor regions 121. Dielectric liner 118 may include any number of dielectric layers and/or materials. In some embodiments, dielectric liner 118 includes silicon nitride. Dielectric liner 118 may include the same material composition as the dielectric material of fin isolation structure 116. In some examples, fin isolation structure 116 and dielectric liner 118 are formed during the same dielectric deposition process using atomic layer deposition (ALD), chemical vapor deposition (CVD), or plasma enhanced chemical vapor deposition (PECVD). In some embodiments, dielectric liner 118 extends below a bottommost surface of gate structures 108 and/or a bottommost surface of source or drain regions 106, as described above with respect to fin isolation structure 116. Note that because the trench for fin isolation structure 119 is wider than the trench for fin isolation structure 116, it may extend deeper into dielectric structure 102 (the higher height-to-width aspect ratio trench of 116 may etch slower than the relatively wider trench having dielectric liner 118). The dielectric liner 118 may have a thickness, for instance, between about 5 nm and about 10 nm, between about 5 nm and about 15 nm, or between about 10 nm and about 20 nm. Other examples may be configured differently.

Conductive via 120 may include any suitable conductive material. In some examples, conductive via 120 includes any of tungsten, molybdenum, ruthenium, copper, or cobalt. Conductive via 120 may include any number of barrier layers and a conductive fill on the barrier layers. For example, conductive via 120 may include a barrier layer that includes titanium nitride or tantalum nitride. According to some embodiments, conductive via 120 extends below a bottommost surface of dielectric liner 118. Conductive via 120 has a width along the first direction that is greater than a width of gate structure 108 along the first direction. In some examples, conductive via 120 has a width that is at least 1.5 times, at least 2 times, at least 2.5 times, or at least 3 times wider than the width of gate structure 108 along the first direction.

According to some embodiments, fin isolation structure 119 may extend across two adjacent gate trenches and be isolated from the remaining portions of the adjacent gate trenches by gate cuts 122, as illustrated in the plan view of Figure 1B. Gate cuts 122 extend lengthwise along the first direction and may cut across any number of gate trenches. In the illustrated example, gate cuts 122 extend along the first direction on either side of fin isolation structure 119. Gate cuts 122 may extend in the third direction (e.g., into the page of Figure 1B) through at least an entire thickness of the gate structures within the gate trenches. Gate cuts 122 may include any suitable dielectric material, such as silicon nitride, silicon dioxide, or silicon oxynitride. A top surface of gate cuts 122 may be polished to be substantially coplanar with a top surface of spacer structures 110.

According to some embodiments, another dielectric fill 124 may be present adjacent to source or drain regions 106 (e.g., between adjacent source or drain regions 106) along a given source/drain trench. In some examples, dielectric fill 124 is substantially the same as dielectric fill 114 that together occupy a remaining volume within the source/drain trenches around and over portions of source or drain regions 106. Dielectric fill 124 may be any suitable dielectric material, such as silicon dioxide.

### Fabrication Methodology

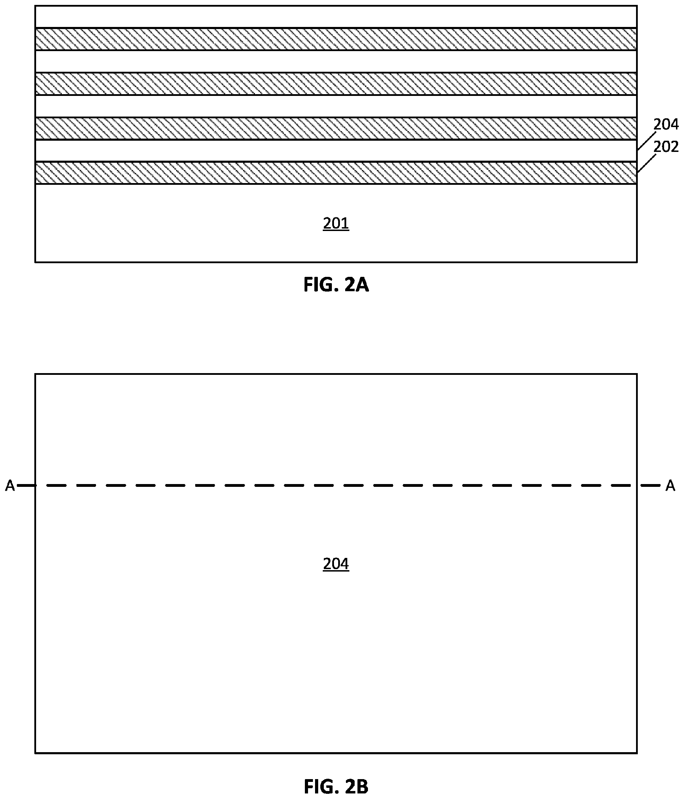

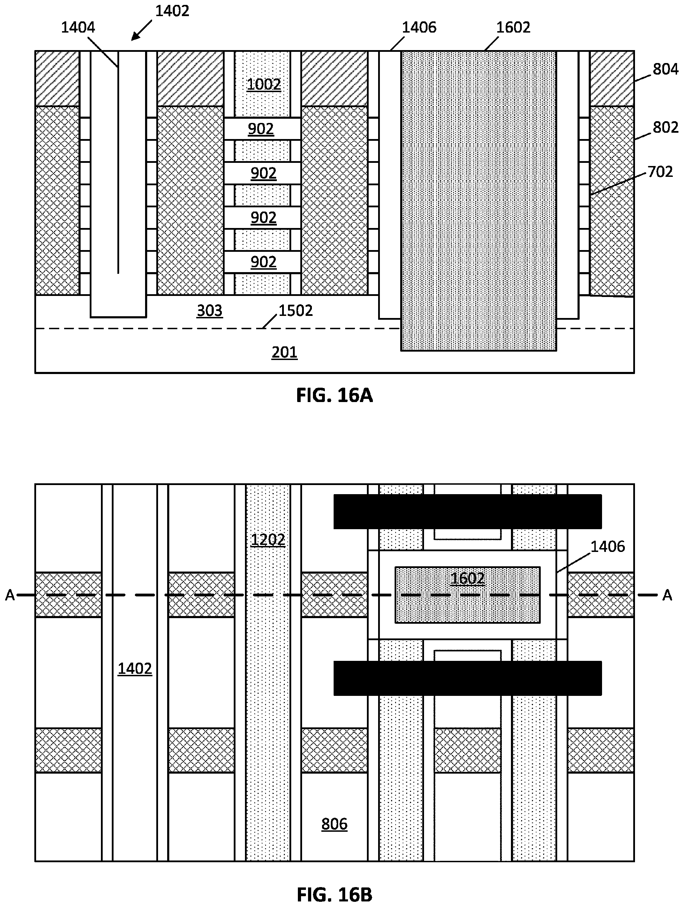

Figures 2A - 16A and 2B - 16B include cross-sectional and plan views that collectively illustrate an example process for forming an integrated circuit configured with a conductive via through a fin isolation structure, in accordance with an embodiment of the present disclosure. The cross-section of Figures 2A - 16A is taken across the dashed line A-A illustrated in the top-down view of each of Figures 2B - 16B. Figures 2A - 16A represent a similar cross-sectional view as that of Figure 1A across a series of semiconductor devices, while Figures 2B - 16B represent a similar plan view as that of Figure 1B across a series of different semiconductor devices. Each set of figures sharing the same letter shows an example structure that results from the process flow up to that point in time, so the depicted structure evolves as the process flow continues, culminating in the structure shown in Figures 16A - 16B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure.

Figure 2A illustrates a cross-sectional view taken through a substrate 201 having a series of material layers formed over substrate 201, and Figure 2B illustrates a top-down view of the structure, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or SiGe), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 include a semiconductor material suitable for use as a nanoribbon such as silicon (Si), SiGe, germanium, or III-V materials like indium phosphide (InP) or gallium arsenide (GaAs). Sacrificial layers 202 include a material that can be selectively removed relative to semiconductor layers 204. In some examples, for instance, semiconductor layers 204 are silicon and sacrificial layers 202 are SiGe, or vice-versa. In some other examples where SiGe is used in each of semiconductor layers 204 and in sacrificial layers 202, the germanium concentration is different between semiconductor layers 204 and sacrificial layers 202, so as to allow for etch selectivity. For example, semiconductor layers 204 may include a higher germanium content compared to sacrificial layers 202.

While dimensions can vary from one example embodiment to the next, the thickness of each semiconductor layer 204 may be between about 5 nm and about 20 nm, in some examples. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any material deposition technique, CVD, PECVD, physical vapor deposition (PVD), ALD, or epitaxial growth.

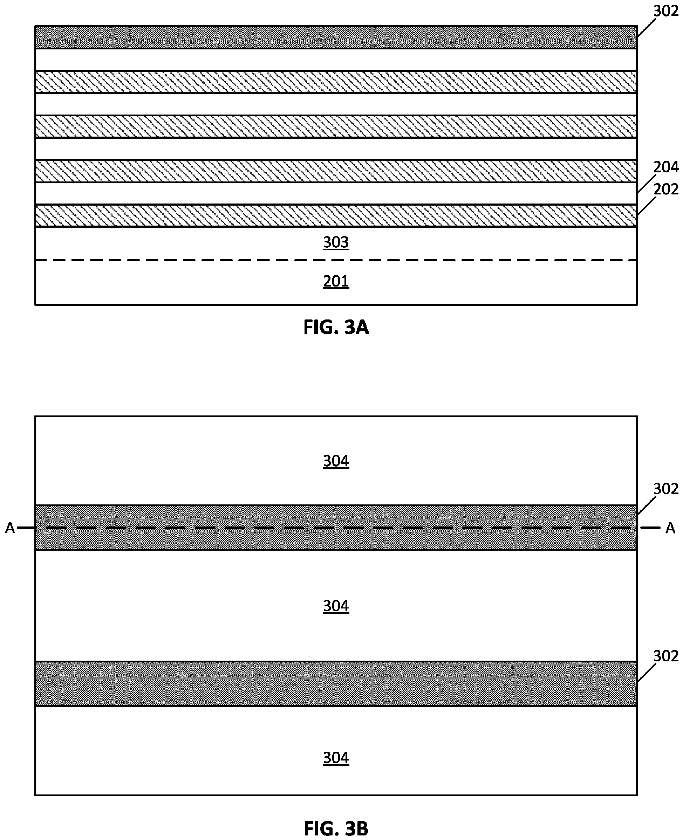

Figures 3A and 3B depict the cross-section and top-down views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows (as shown in Figure 3B) to form corresponding rows of fins from the alternating layer stack of sacrificial layers 202 and semiconductor layers 204. Cap layer 302 extends along the top of each fin in a first direction, such that Figure 3A illustrates a cross-section take along a given fin.

According to some embodiments, an anisotropic etching process through the layer stack continues into at least a portion of substrate 201. Portions of substrate 201 beneath the fins are not etched and yield subfin regions 303 directly beneath the stack of alternating material layers. The etched portions of substrate 201 that are not under the fins may be filled with a dielectric fill 304 that acts as shallow trench isolation (STI) between adjacent fins. Dielectric fill 304 extends in the first direction along the sides of subfin regions 303 adjacent to the fins as illustrated in Figure 3B. Dielectric fill 304 may be any suitable dielectric material such as silicon dioxide. Subfin regions 303 represent remaining portions of substrate 201 flanked by dielectric fill 304, according to some embodiments.

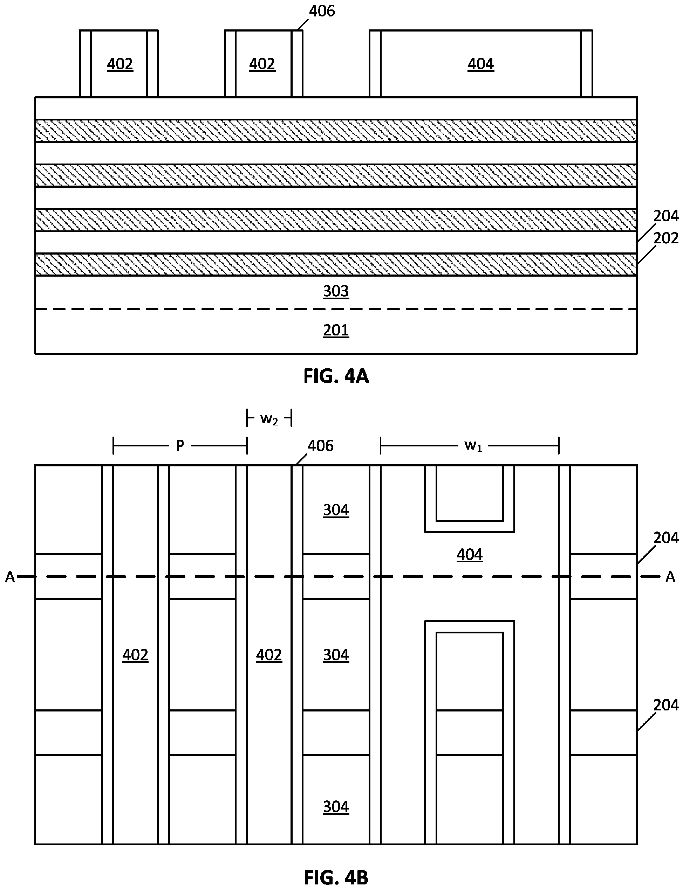

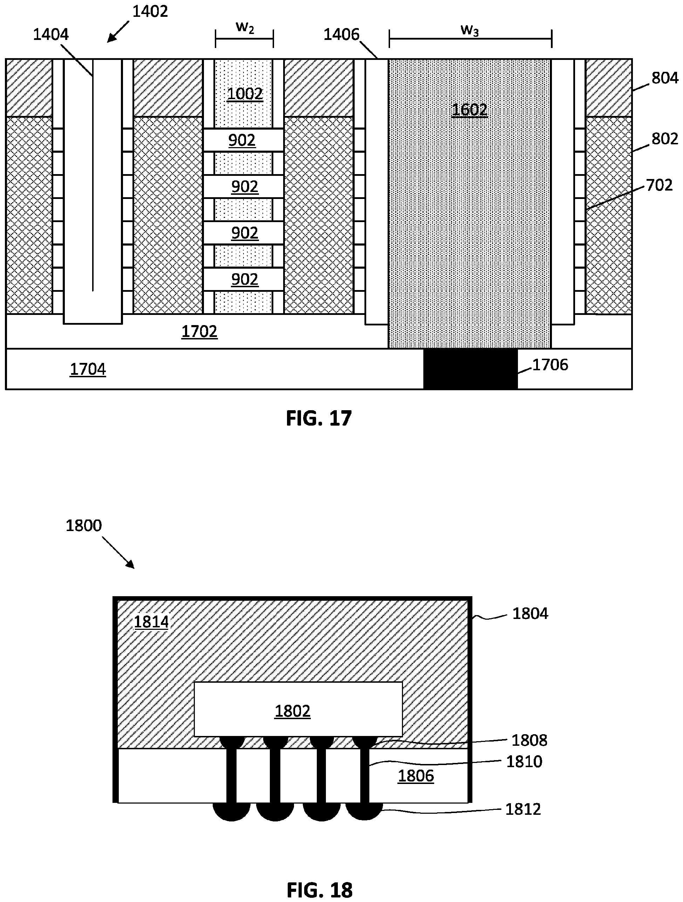

Figures 4A and 4B depict cross-section views of the structures shown in Figures 3A and 3B following the formation of first sacrificial gates 402, one or more second sacrificial gates 404, and spacer structures 406, according to some embodiments. A gate masking layer may first be patterned in strips that extend orthogonally across each of the fins (e.g., in a second direction) in order to form corresponding first sacrificial gates 402 in strips beneath the gate masking layers. Afterwards, the gate masking layers may be removed or may remain as a cap layer above each of first sacrificial gates 402. Second sacrificial gate 404 may be formed by merging the sacrificial gate material along the first direction across two adjacent strips of sacrificial gates, as illustrated in figure 4B. Accordingly, at least a portion of second sacrificial gate 404 is wider along the first direction compared to widths of first sacrificial gates 402 along the first direction. In some embodiments, the width (w₁) of second sacrificial gate 404 is based on the pitch (P) between adjacent strips of first sacrificial gates 402. For example, width w₁ may be roughly equal to the pitch P plus the width (w₂) of one first sacrificial gate 402. Width w₁ may be at least 1.5, 2.0, 2.5, or 3 times larger than width w₂. Note that pitch P may generally be preserved in the final structure, as shown in Figure 17.

According to some embodiments, the sacrificial gate material is removed in all areas not protected by the gate masking layers. First sacrificial gates 402 and second sacrificial gate 404 may be any suitable material that can be selectively removed without damaging the semiconductor material of the fins. In some examples, the sacrificial material of first and second sacrificial gates 402/404 includes polysilicon.

According to some embodiments, spacer structures 406 are formed along the sidewalls of first sacrificial gates 402 and one or more second sacrificial gates 404. Spacer structures 406 may be conformally deposited (e.g., CVD or ALD)_and then etched back or otherwise removed (e.g., via anisotropic or directional etch) from horizontal surfaces, such that spacer structures 406 remain mostly only on sidewalls of any exposed structures. The width of spacer structures 406 (along the first direction) may vary from one example to the next, but in some cases is in the range of 3 nm to 20 nm. According to some embodiments, spacer structures 406 may be any suitable dielectric material, such as silicon nitride, silicon carbon nitride, or silicon oxycarbonitride. In one such embodiment, spacer structures 406 comprise a nitride and dielectric fill 304 adjacent to subfin regions 303 comprises an oxide, so as to provide a degree of etch selectivity during final gate processing.

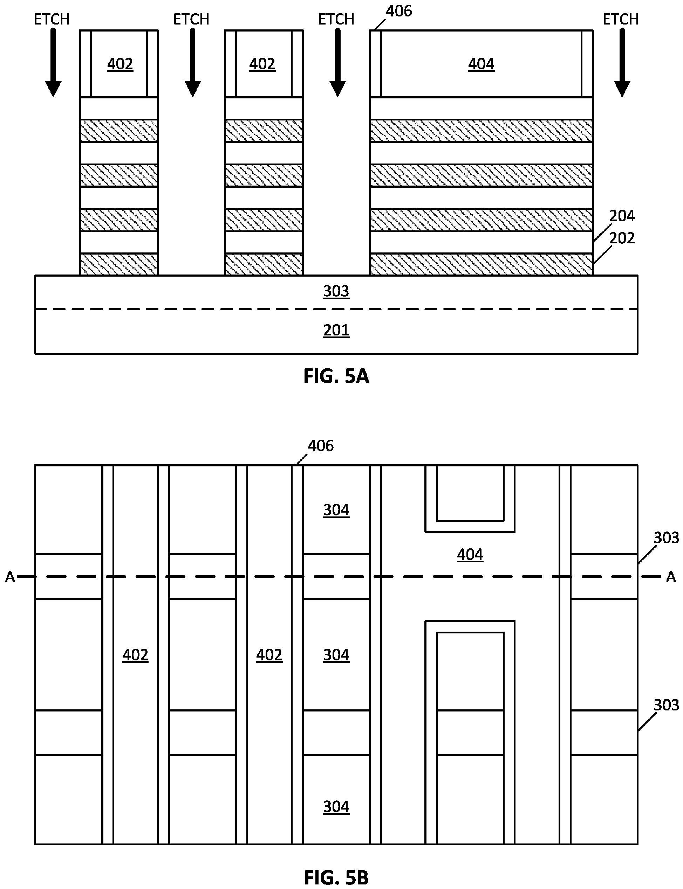

Figures 5A and 5B depict cross-section and top-down views of the structures shown in Figures 4A and 4B following the removal of exposed portions of the fins not protected by sacrificial gates 402/404 and spacer structures 406, according to some embodiments. The exposed fin portions may be removed using any anisotropic etching process, such as reactive ion etching (RIE) or other directional etch process. The removal of the exposed fin portions creates source or drain trenches that alternate with gate trenches (currently filled with sacrificial gates 402 or 404) along the first direction, according to some embodiments. In some embodiments, at least a portion of subfin regions 303 is also removed such that a top surface of subfin regions 303 is recessed below a top surface of the adjacent dielectric fill 304. The recessed area above subfin regions 303 may be filled with one or more dielectric materials.

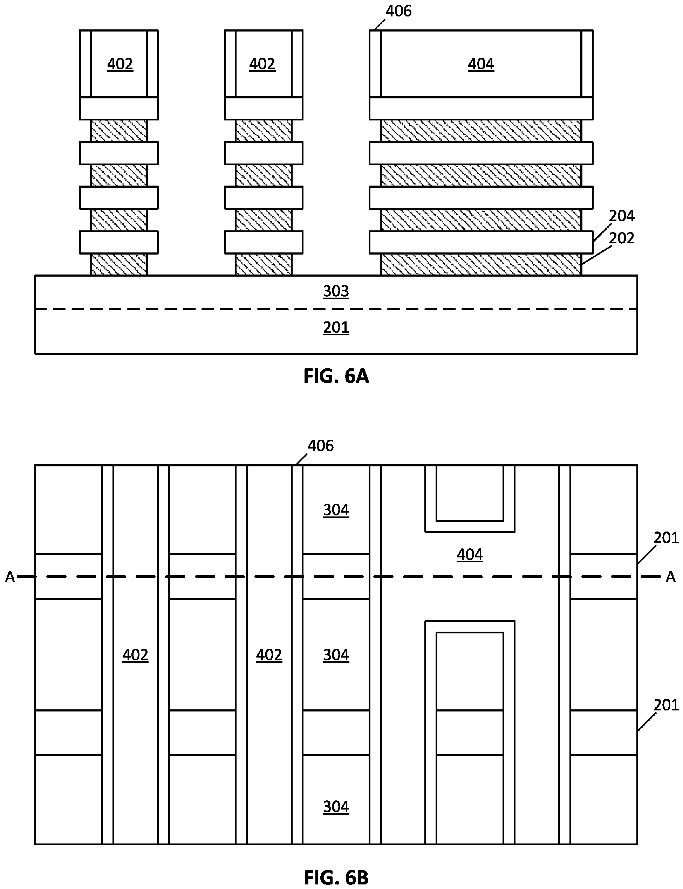

Figures 6A and 6B depict cross-section views of the structures shown in Figures 5A and 5B following the removal of portions of sacrificial layers 202, according to an embodiment of the present disclosure. An isotropic etching process may be used to selectively recess the exposed ends of each sacrificial layer 202 (e.g., while etching comparatively little of semiconductor layers 204).

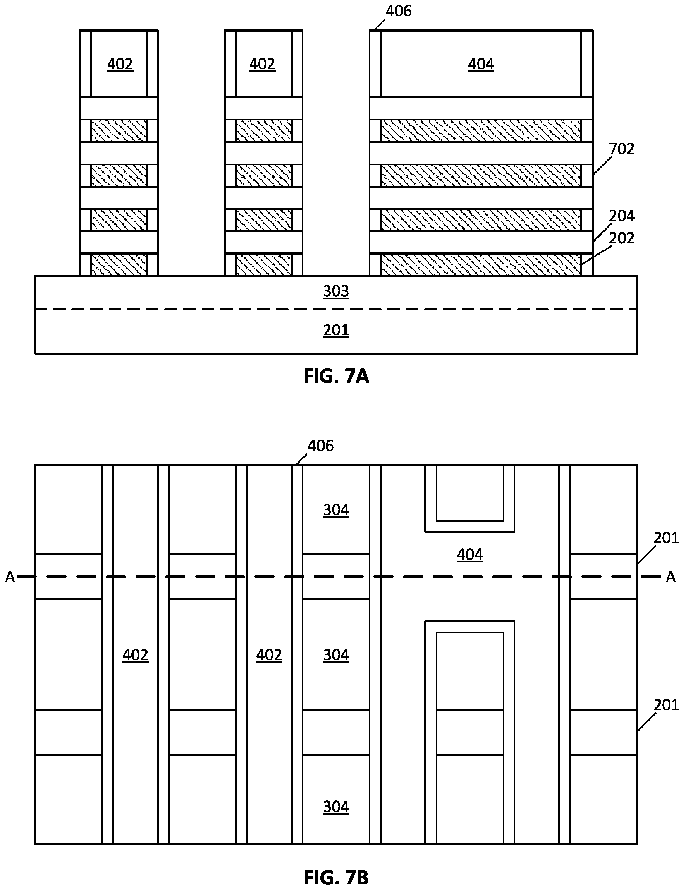

Figures 7A and 7B depict cross-section views of the structures shown in Figures 6A and 6B following the formation of internal spacers 702, according to an embodiment of the present disclosure. Internal spacers 702 may have a material composition that is similar to or the exact same as spacer structures 406. Accordingly, internal spacers 702 may be any suitable dielectric material that exhibits high etch selectively to semiconductor materials such as silicon and/or silicon germanium. Internal spacers 702 may be, for example, conformally deposited over the sides of the fin structure using a conformal deposition process like CVD or ALD and then etched back using an isotropic etching process to expose the ends of semiconductor layers 204. According to some embodiments, internal spacers 702 have a similar width (e.g., along the first direction) to spacer structures 406.

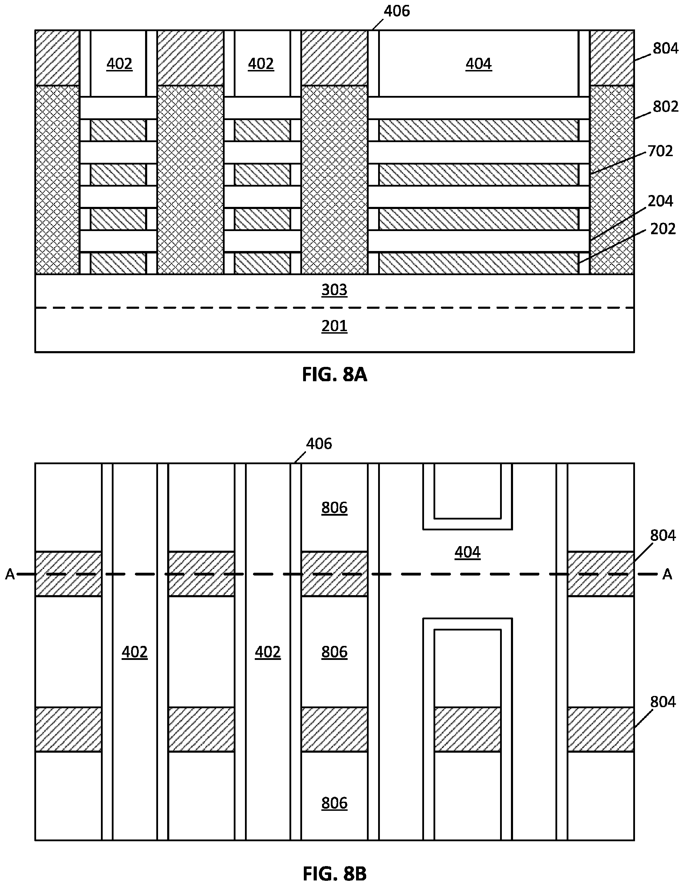

Figures 8A and 8B depict cross-section views of the structure shown in Figures 7A and 7B, respectively, following the formation of source or drain regions 802 within the source/drain trenches, according to some embodiments. Source or drain regions 802 may be formed in the areas that had been previously occupied by the exposed fins between spacer structures 406. According to some embodiments, source or drain regions 802 are epitaxially grown from the exposed semiconductor material at the ends of semiconductor layers 204. Any of source or drain regions 802 may be p-channel source or drain regions (e.g., epitaxial silicon germanium with p-type dopants) or n-channel source or drain regions (e.g., epitaxial silicon with n-type dopants).

According to some embodiments, a dielectric fill 804 is provided over source or drain regions 802. Another dielectric fill 806 may be present adjacent to source or drain regions 802 (e.g., between adjacent source or drain regions 802) along a given source/drain trench. In some examples, dielectric fill 804 and dielectric fill 806 are the same dielectric fill that occupies a remaining volume within the source/drain trenches around and over portions of source or drain regions 802. In some examples, dielectric fill 804/806 extends up to and planar with a top surface of spacer structures 406 (e.g., following a polishing procedure). Dielectric fill 804/806 may be any suitable dielectric material, such as silicon dioxide.

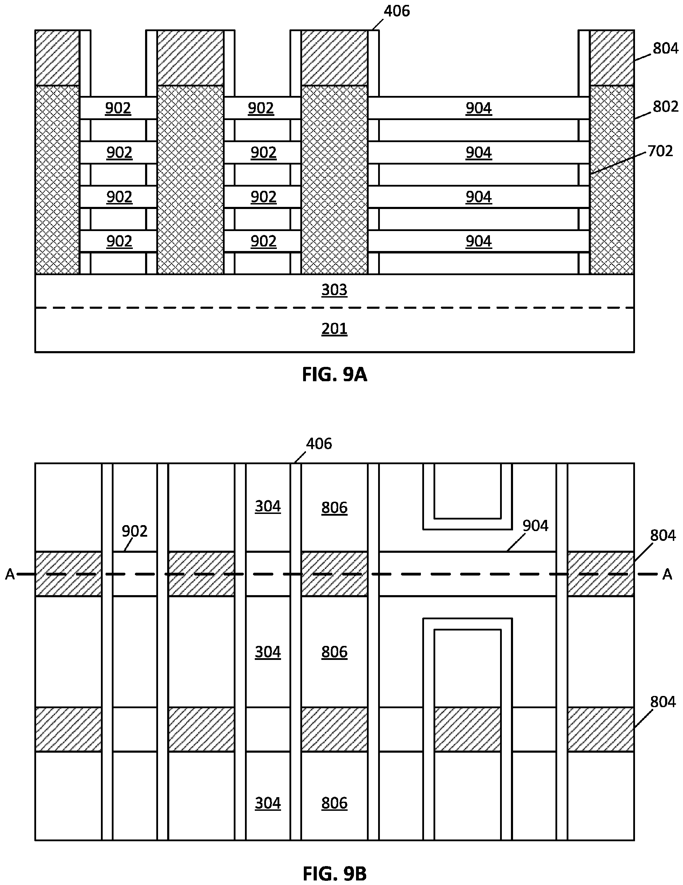

Figures 9A and 9B depict cross-section and top-down views of the structure shown in Figures 8A and 8B, respectively, following the removal of sacrificial gates 402/404 and sacrificial layers 202, according to some embodiments. In examples where gate masking layers are still present, they may be removed at this time. Once sacrificial gates 402/404 are removed, the remaining fin portions extending between spacer structures 406 are exposed.

In the example where the fins include alternating sacrificial layers 202 and semiconductor layers 204, sacrificial layers 202 are selectively removed to leave behind first nanoribbons 902 extending along the first direction between corresponding source or drain regions 802 and second nanoribbons 904 extending along the first direction between corresponding source or drain regions 802. Each vertical set of first nanoribbons 902 represents the semiconductor region (also called channel region) of a different semiconductor device. It should be understood that first nanoribbons 902 may also be nanowires or nanosheets. Sacrificial gates 402/404 and sacrificial layers 202 may be removed using the same isotropic etching process or different isotropic etching processes.

According to some embodiments, second nanoribbons 904 are longer along the first direction compared to first nanoribbons 902. This is due to the patterned width of second sacrificial gate 404 being wider than the patterned width of first sacrificial gate 402, according to some embodiments.

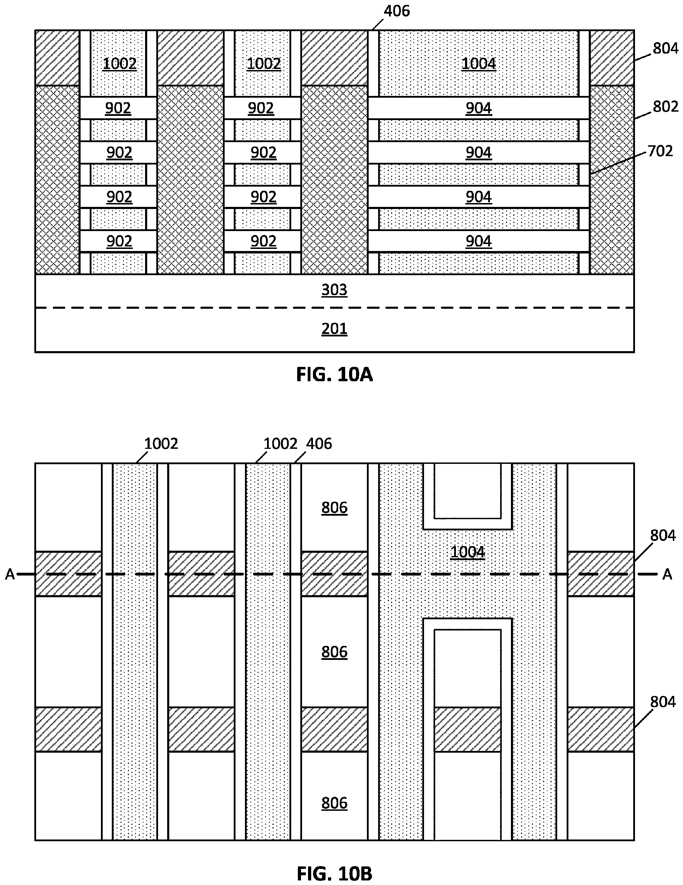

Figures 10A and 10B depict cross-section and top-down views of the structure shown in Figures 9A and 9B, respectively, following the formation of first gate structures 1002 around the suspended first nanoribbons 902 and second gate structures 1004 around the suspended second nanoribbons 904, according to an embodiment of the present disclosure. As noted above, gate structures 1002/1004 each include a gate dielectric and a gate electrode.

The gate dielectric may be conformally deposited around nanoribbons 902/904 using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on nanoribbons 902/904, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary conductive material that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. In an example, any of gate structures 1002/1004 include p-type workfunction materials such as, for example, titanium nitride. In an example, any of gate structures 1002/1004 include n-type workfunction materials such as tungsten or titanium aluminum carbide.

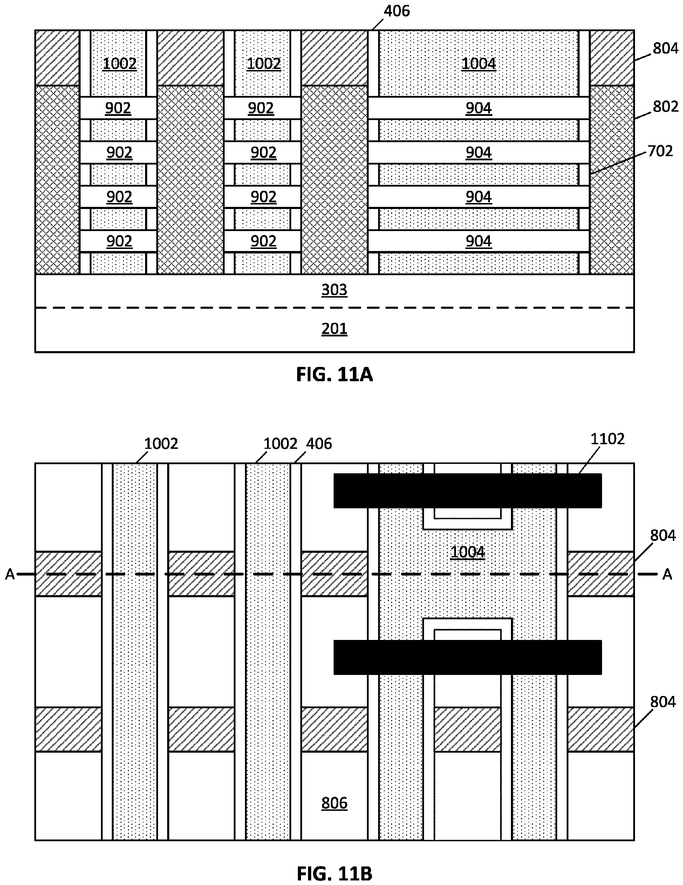

Figures 11A and 11B depict cross-section and top-down views of the structure shown in Figures 10A and 10B, respectively, following the formation of one or more gate cuts 1102, according to some embodiments. Gate cuts 1102 may be formed by etching a trench along the first direction that cuts across any number of gate trenches to electrically isolate the gate structures on either side of the trench. The trench is then filled with one or more dielectric materials to form gate cuts 1102. In the illustrated example of Figure 11B, gate cuts 1102 are formed on either side of second gate structure 1004 to isolate second gate structure 1004 from any other gate regions further along the gate trenches in the second direction (e.g., up and down the page of Figure 11B). Gate cuts 1102 may include any suitable dielectric material. In some examples, gate cuts 1102 include a dielectric liner and a dielectric fill on the dielectric liner. The dielectric liner may include a high-k dielectric material, such as silicon nitride, and the dielectric fill may include a low-k dielectric material, such as silicon dioxide. A top surface of gate cuts 1102 may be polished to be substantially coplanar with a top surface of spacer structures 406.

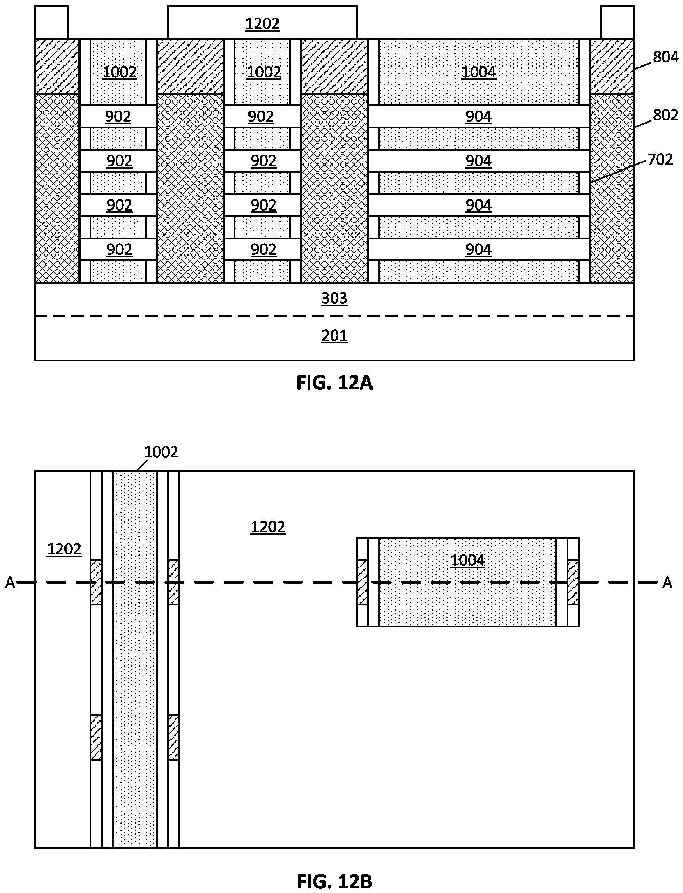

Figures 12A and 12B depict cross-section and top-down views of the structure shown in Figures 11A and 11B, respectively, following the formation of a mask structure 1202 on the top surface of the integrated circuit, according to some embodiments. Mask structure 1202 may be any suitable hard mask material, such as a dielectric material (e.g., silicon dioxide) or carbon hard mask (CHM), or it may be a photoresist. According to some embodiments, mask structure 1202 is lithographically patterned to expose portions of first gate structures 1002 and second gate structure 1004 that are to be removed. Any portions of first gate structures 1002 that are exposed may be replaced with fin isolation structures, according to some embodiments. Any portion of second gate structure 1004 that is exposed may be replaced with a fin isolation structure having a conductive via passing through it, as will be discussed in more detail herein.

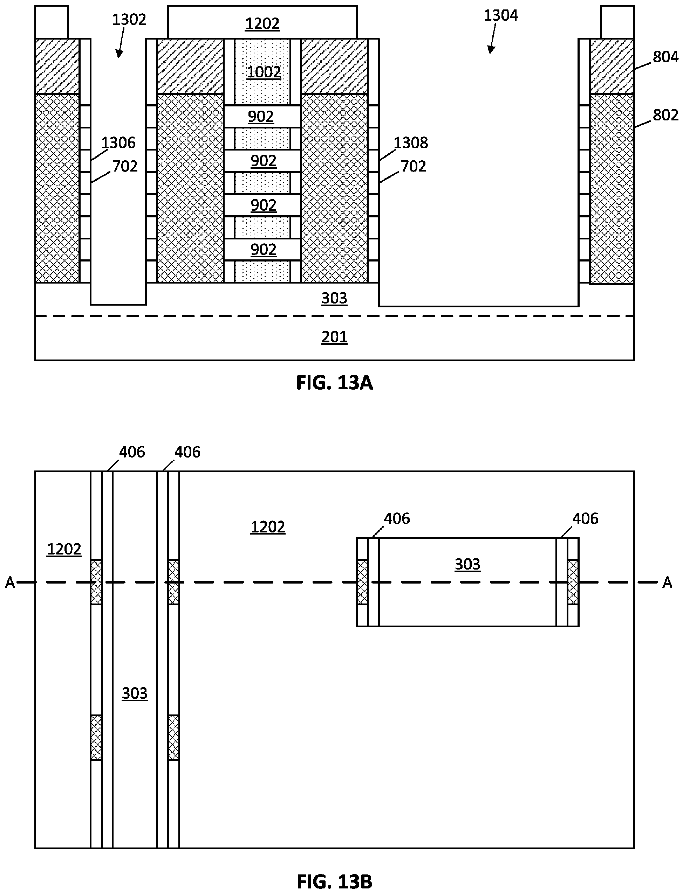

Figures 13A and 13B depict cross-section and top-down views of the structure shown in Figures 12A and 12B, respectively, following the formation of a first opening 1302 through at least a portion of first gate structure 1002 and a second opening 1304 through at least a portion of second gate structure 1004, according to some embodiments. First opening 1302 may extend through at least an entire thickness of first gate structure 1002 and may be bound along the first direction by spacer structures 406. First opening 1302 may have a trench-like shape that runs lengthwise along the gate trench in the second direction. First opening 1302 may extend below a top surface of subfin region 303 and may extend further into a portion of substrate 201. Note that first nanoribbons 902 are also removed within first opening 1302. Second opening 1304 may extend through at least an entire thickness of second gate structure 1004 and likewise into at least a portion of subfin region 303. In some examples, second opening 1304 extends further into at least a portion of substrate 201. Second opening may also be bound along the first direction by spacer structures 406. Note that second nanoribbons 904 are also removed within second opening 1304.

According to some embodiments, first opening 1302 and second opening 1304 may be formed using the same anisotropic etching process, such as RIE. The etching process may remove both metal material and dielectric material from gate structures 1002/1004 as well as semiconductor material from first nanoribbons 902 and second nanoribbons 904. Accordingly, the etching process may be rough and could result in visible damage to the top portions of the exposed spacer structures 406 or exposed top portions of dielectric fill 804. Exposed portions of first nanoribbons 902 and second nanoribbons 904 within the respective gate trenches may be removed by the etching process while some portions of first nanoribbons 902 and second nanoribbons 904 are protected by inner spacers 702. As a result, first nanoribbon stubs 1306 may be interspersed with inner spacers 702 along the walls of first opening 1302 and second nanoribbon stubs 1308 may be interspersed with inner spacers 702 along the walls of second opening 1304. First nanoribbon stubs 1306 are end portions of first nanoribbons 902 that contact source or drain regions 802, and second nanoribbon stubs 1308 are end portions of second nanoribbons 904 that contact source or drain regions 802, according to some embodiments.

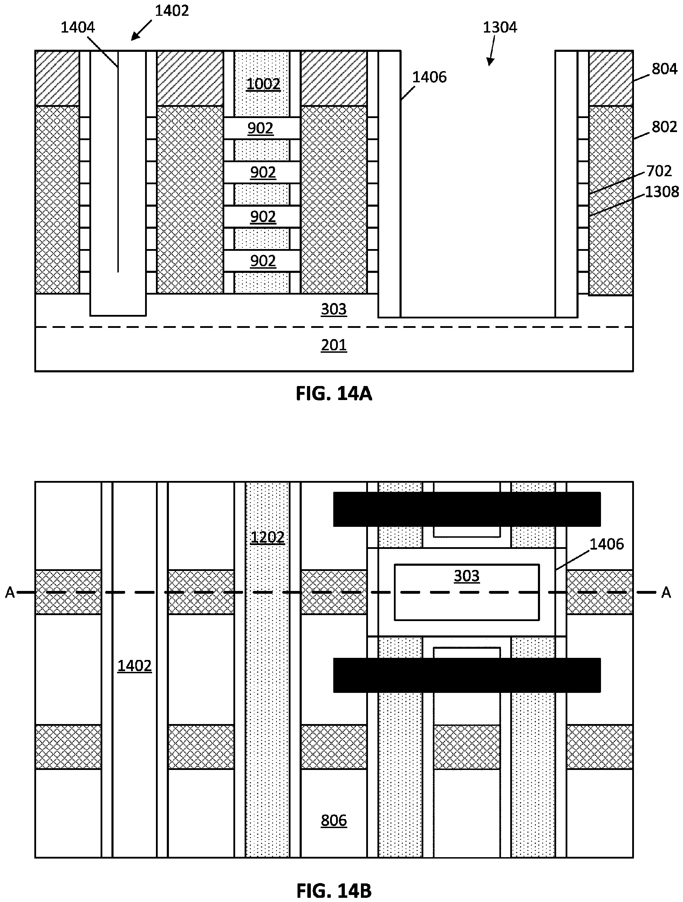

Figures 14A and 14B depict cross-section and top-down views of the structure shown in Figures 13A and 13B, respectively, following the deposition of a dielectric material to form various structures, according to some embodiments. A fin isolation structure 1402 may be formed by depositing the dielectric material within first opening 1302, such that the dielectric material substantially fills the volume of first opening 1302. In some embodiments, the dielectric material forms inwards starting on the sidewalls of first opening 1302, which results in a seam 1404 or void along a central plane of fin isolation structure 1402.

According to some embodiments, the dielectric material also forms a dielectric liner 1406 on sidewalls of second opening 1304. Dielectric liner 1406 may have a lateral thickness of between about 5 nm and about 10 nm, between about 5 nm and about 15 nm, or between about 10 nm and about 20 nm. Note that dielectric liner 1406 may form directly on the exposed second nanoribbon stubs 1308 and inner spacers 702 on the sidewalls of second opening 1304.

The dielectric material may be deposited using any suitable conformal deposition technique, such as ALD, CVD, or PECVD. The dielectric material may be any suitable dielectric, such as silicon nitride. According to some embodiments, the dielectric material is deposited and then etched back to remove the exposed dielectric material across horizontal surfaces and to remain on any exposed sidewalls, such as on the sidewalls of openings 1302 and 1304.

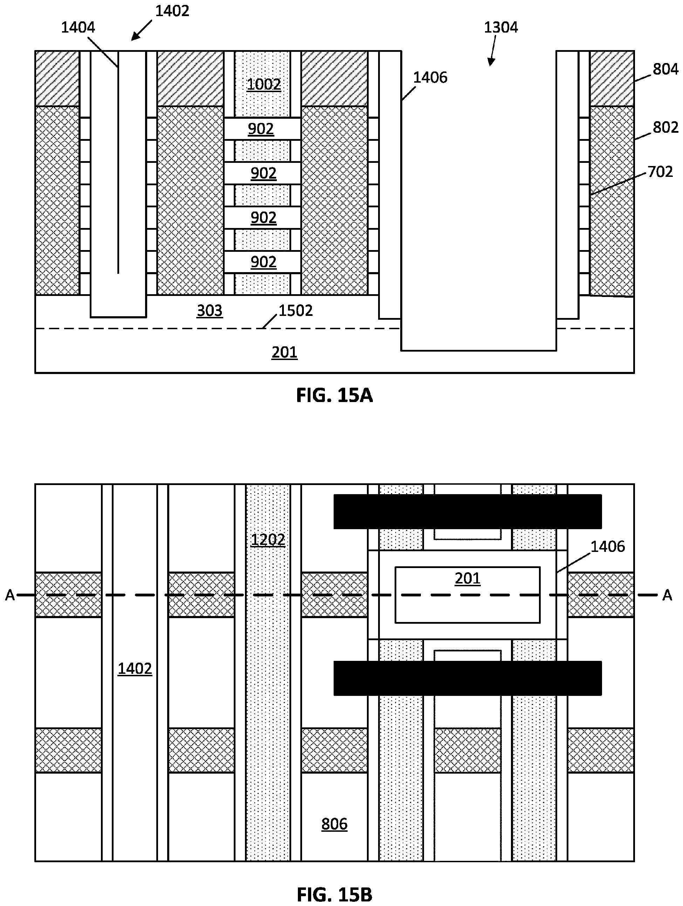

Figures 15A and 15B depict cross-section and top-down views of the structure shown in Figures 14A and 14B, respectively, following an additional recessing of opening 1304, according to some embodiments. According to some embodiments, an anisotropic semiconductor etch (e.g., RIE) may be performed to etch through the exposed semiconductor surface at the bottom of second opening 1304. In some examples, the bottom of second opening 1304 is recessed further until it is at least below the bottom surface of subfin regions 303 and adjacent dielectric fill 304 as indicated by the dashed line 1502.

Figures 16A and 16B depict cross-section and top-down views of the structure shown in Figures 15A and 15B, respectively, following the formation of a conductive via 1602 within the remaining volume of second opening 1304, according to some embodiments. Conductive via 1602 may include any suitable conductive material, such as tungsten, molybdenum, ruthenium, or cobalt. In some examples, conductive via 1602 includes a barrier layer of titanium nitride or tantalum nitride directly on dielectric liner 1406. Due to the depth of second opening 1304, a bottom surface of conductive via 1602 extends into substrate 201 (e.g., below a bottom surface of subfin region 303 and adjacent dielectric fill 304), which facilitates connection with backside contacts. A top surface of conductive via 1602 may be polished to be substantially coplanar with a top surface of spacer structures 406 and/or a top surface of first gate structure 1002 and/or a top surface of fin isolation structure 1402. The location of conductive via 1602 serves a dual purpose of providing a through-via connection and also providing a fin isolation structure along the same fin direction that includes first nanoribbons 902. In some examples, a frontside interconnect structure including one or more interconnect layers may be formed above the resulting integrated circuit structure. Each interconnect layer may include dielectric material and one or more conductive interconnect features (e.g., lines and vias) to route signals and/or power to and from the various transistor devices or other features.

Figure 17 depicts a cross-section view of the structure shown in Figure 16A following the backside removal of substrate 201 and subsequent backside processing to form a backside connection to conductive via 1602, according to some embodiments. Substrate 201 may be removed from the backside via any combination of grinding, polishing, and/or etching processes. In some embodiments, substrate 201 may continue to be thinned from the backside until bottom surfaces of dielectric fill 304 or subfin regions 303 are exposed. In some examples, the backside polishing continues until a bottom surface of conductive via 1602 is exposed.

Any remaining portion of subfin regions 303 may be removed using an isotropic etching process that removed the semiconductor material (e.g., silicon) of subfin regions 303. A first backside dielectric structure 1702 may be formed following the removal of subfin regions 303. In some embodiments, first backside dielectric structure 1702 includes the same material as dielectric fill 304, such that there is little to no discernable difference between them. First backside dielectric structure 1702 may be any suitable dielectric material, such as silicon dioxide, silicon nitride, or silicon oxynitride. According to some embodiments, first backside dielectric structure 1702 is polished following its deposition such that a bottom surface of first backside dielectric structure 1702 is substantially coplanar with a bottom surface of conductive via 1602.

According to some embodiments, a second backside dielectric structure 1704 may be formed on the bottom surface of first backside dielectric structure 1702. Second backside dielectric structure 1704 may include any suitable dielectric material, such as the same dielectric material as first backside dielectric structure 1702. A backside contact 1706 may be formed through a thickness of second backside dielectric structure 1704 to make contact with a bottom surface of conductive via 1602. Backside contact 1706 may be any suitable conductive material, such as tungsten, molybdenum, ruthenium, or cobalt.

First gate structure 1002 has substantially the same width w₂ across its top surface as first sacrificial gate 402, as discussed above. Conductive via 1602 may have a width w₃ across its top surface and along the first direction that is greater than the width w₂ of first gate structure 1002. In some examples, the width w₃ of conductive via 1602 is at least 1.5 times, at least 2.0 times, at least 2.5 times, or at least 3 times greater than the width w₂ of first gate structure 1002. In some examples, the width w₂ is between about 20 nm and about 40 nm and the width w₃ is between about 50 nm and about 100 nm. Note that widths w₁ and w₂ may be largely preserved from the structure shown in Figures 4A-B to the structure shown in Figure 17 (depending on factors such as the height-to-width aspect ratio of openings 1302 and 1304 and etch selectivity of dielectric materials for spacer structures 406 and inner spacers 702), and width w₃ is less than width w₁ (e.g., due to the presence of dielectric liner 1406).

In some examples, a backside interconnect structure including one or more interconnect layers may be formed below the resulting integrated circuit structure. Each interconnect layer may include dielectric material and one or more conductive interconnect features (e.g., lines and vias) to route signals and/or power to and from the various transistor devices or other features.

Figure 18 illustrates an example embodiment of a chip package 1800, in accordance with an embodiment of the present disclosure. As can be seen, chip package 1800 includes one or more dies 1802. One or more dies 1802 may include at least one integrated circuit having semiconductor devices, such as any of the semiconductor devices disclosed herein. One or more dies 1802 may include any other circuitry used to interface with other devices formed on the dies, or other devices connected to chip package 1800, in some example configurations.

As can be further seen, chip package 1800 includes a housing 1804 that is bonded to a package substrate 1806. The housing 1804 may be any standard or proprietary housing, and may provide, for example, electromagnetic shielding and environmental protection for the components of chip package 1800. The one or more dies 1802 may be conductively coupled to a package substrate 1806 using connections 1808, which may be implemented with any number of standard or proprietary connection mechanisms, such as solder bumps, ball grid array (BGA), pins, or wire bonds, to name a few examples. Package substrate 1806 may be any standard or proprietary package substrate, but in some cases includes a dielectric material having conductive pathways (e.g., including conductive vias and lines) extending through the dielectric material between the faces of package substrate 1806, or between different locations on each face. In some embodiments, package substrate 1806 may have a thickness less than 1 millimeter (e.g., between 0.1 millimeters and 0.5 millimeters), although any number of package geometries can be used. Additional conductive contacts 1812 may be disposed at an opposite face of package substrate 1806 for conductively contacting, for instance, a printed circuit board (PCB). One or more vias 1810 extend through a thickness of package substrate 1806 to provide conductive pathways between one or more of connections 1808 to one or more of contacts 1812. Vias 1810 are illustrated as single straight columns through package substrate 1806 for ease of illustration, although other configurations can be used (e.g., damascene, dual damascene, through-silicon via, or an interconnect structure that meanders through the thickness of substrate 1806 to contact one or more intermediate locations therein). In still other embodiments, vias 1810 are fabricated by multiple smaller stacked vias, or are staggered at different locations across package substrate 1806. In the illustrated embodiment, contacts 1812 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1812, to inhibit shorting.

In some embodiments, a mold material 1814 may be disposed around the one or more dies 1802 included within housing 1804 (e.g., between dies 1802 and package substrate 1806 as an underfill material, as well as between dies 1802 and housing 1804 as an overfill material). Although the dimensions and qualities of the mold material 1814 can vary from one embodiment to the next, in some embodiments, a thickness of mold material 1814 is less than 1 millimeter. Example materials that may be used for mold material 1814 include epoxy mold materials, as suitable. In some cases, the mold material 1814 is thermally conductive, in addition to being electrically insulating.

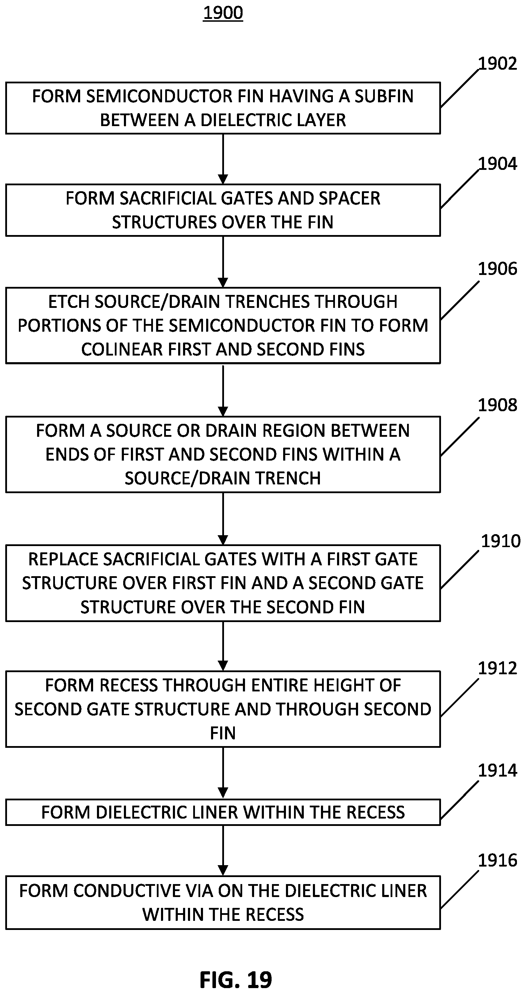

Figure 19 is a flow chart of a method 1900 for forming at least a portion of an integrated circuit, according to an embodiment. Various operations of method 1900 may be illustrated in Figures 2A - 16A and 2B - 16B. However, the correlation of the various operations of method 1900 to the specific components illustrated in the aforementioned figures is not intended to imply any structural and/or use limitations. Rather, the aforementioned figures provide one example embodiment of method 1900. Other operations may be performed before, during, or after any of the operations of method 1900. For example, method 1900 does not explicitly describe various standard processes that are usually performed to form transistor structures. Some of the operations of method 1900 may be performed in a different order than the illustrated order.

Method 1900 begins with operation 1902 where a fin of a plurality of parallel semiconductor fins is formed, according to some embodiments. The semiconductor material in the fin may be formed from a substrate such that the fin is an integral part of the substrate (e.g., etched from a bulk silicon substrate). Alternatively, the fin can be formed of material deposited onto an underlying substrate. In one such example case, a blanket layer of SiGe can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fin includes alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches, according to some examples. The fin may also include a cap structure that is used to define the location of the fin during, for example, an RIE process. The cap structure may be a dielectric material, such as silicon nitride.

According to some embodiments, a dielectric fill is formed around a subfin portion of the fin. In some embodiments, the dielectric fill extends between each pair of adjacent parallel fins and runs lengthwise in the same direction as the fins. In some embodiments, the anisotropic etching process that forms the fins also etches into a portion of the substrate and the dielectric fill may be formed within the recessed portions of the substrate. Accordingly, the dielectric fill acts as shallow trench isolation (STI) between adjacent fins. The dielectric fill may be any suitable dielectric material, such as silicon dioxide. Lower portions of the fin adjacent to the dielectric fill may be identified as the subfin.

Method 1900 continues with operation 1904 where sacrificial gates are formed over the fin. The sacrificial gates may be patterned using gate masking layers in strips that run orthogonally over the fin and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fins. In one example, the sacrificial gates include polysilicon. The sacrificial gates may include a first sacrificial gate having a first width along the length of the fin and a second sacrificial gate having as second width along the length of the fin that is greater than the first width.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fins running orthogonally between the strips of sacrificial gates. According to some embodiments, the spacer structures may be any suitable dielectric material, such as silicon nitride or silicon oxynitride.

Method 1900 continues with operation 1906 where exposed portions of the fin are removed to form source/drain trenches. Any exposed portions of the fin not covered by the sacrificial gates or spacer structures may be removed using any anisotropic etching process, such as reactive ion etching (RIE). Sacrificial layers of the fin may be recessed (e.g., via isotropic etch process) followed by deposition of internal spacers (e.g., silicon nitride), as described above. The first sacrificial gate protects a first fin portion and the second sacrificial gate protects a second fin portion that runs colinearly with the first fin portion. These portions of the original fin are herein referred to as the first fin and the second fin.

Method 1900 continues with operation 1908 where source or drain regions are formed at opposite ends of the first and second fins within the source/drain trenches. The source or drain regions may be formed in the areas that had been previously occupied by the exposed fin between the spacer structures. According to some embodiments, the source or drain regions are epitaxially grown from the exposed semiconductor material of the first and second fins (or nanoribbons, nanowires or nanosheets, as the case may be) along the exterior walls of the spacer structures. In some example embodiments, the source or drain regions are NMOS source or drain regions (e.g., epitaxial silicon with n-type dopants) or PMOS source or drain regions (e.g., epitaxial SiGe with p-type dopants). A dielectric fill may be formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth.

Method 1900 continues with operation 1910 where a first gate structure is formed over the semiconductor material of the first fin and a second gate structure is formed over the semiconductor material of the second fin. The first and second sacrificial gates may be removed along with any sacrificial layers within the exposed fins between the spacer structures (in the case of GAA structures). The first and second gate structures may then be formed in place of the first and second sacrificial gates, respectively. The gate structures may each include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 1900 continues with operation 1912 where a recess is formed through at least an entire height of the second gate structure and through any portions of the second fin beneath the second gate structure. According to some embodiments, the recess is formed using an anisotropic etching process, such as RIE. The etching process may remove both metal material and dielectric material from the second gate structure as well as semiconductor material from the second fin. Accordingly, the etching process could result in visible damage to the top portions of the exposed spacer structures adjacent to the recess. According to some embodiments, portions of the semiconductor material from the second fin remain within the sidewalls of the recess as protected by dielectric inner spacer structures. The recess may extend into at least a portion of the subfin region or at least a portion of the substrate.

Method 1900 continues with operation 1914 where a dielectric liner is formed within the recess. The dielectric liner may include any suitable dielectric material, such as silicon nitride. According to some embodiments, the dielectric liner covers the sidewalls of the recess, and may be formed directly on the aforementioned portions of the semiconductor material of the second fin within the sidewalls of the recess. The dielectric material of the dielectric liner may be etched back such that it is removed from at least a portion of the bottom surface of the recess.

Method 1900 continues with operation 1916 where a conductive via is formed within the recess on the dielectric liner. The conductive via may include any suitable conductive material, such as tungsten, molybdenum, ruthenium, or cobalt. In some examples, the conductive via includes a barrier layer of titanium nitride or tantalum nitride directly on the dielectric liner. Due to the depth of the recess, a bottom surface of the conductive via may extend into the substrate (e.g., below a bottom surface of the subfin region and/or below a bottom surface of the dielectric fill adjacent to the subfin region), which facilitates connection with backside contacts. A top surface of the conductive via may be polished to be substantially coplanar with a top surface of the spacer structures and/or a top surface of the adjacent dielectric liner.

### Example System

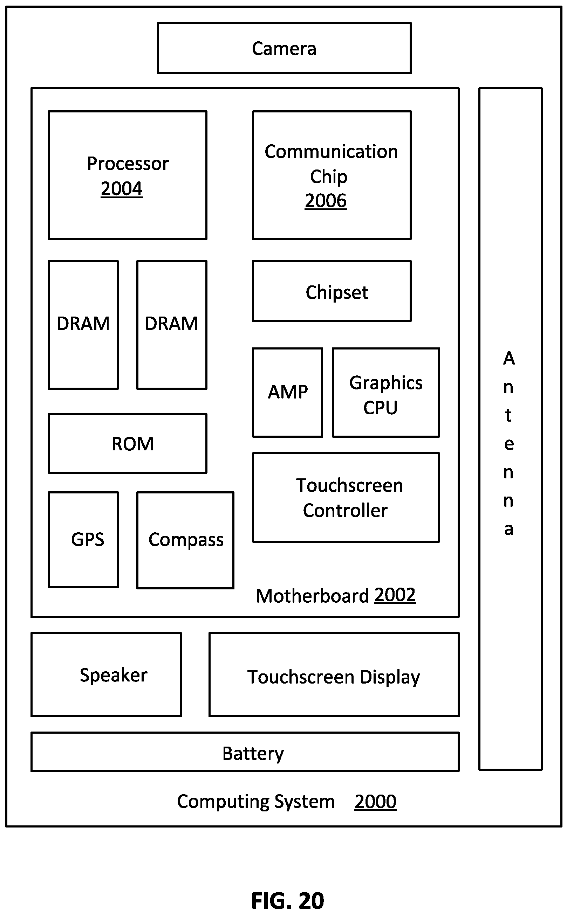

FIG. 20 is an example computing system implemented with one or more of the integrated circuit structures as disclosed herein, in accordance with some embodiments of the present disclosure. As can be seen, the computing system 2000 houses a motherboard 2002. The motherboard 2002 may include a number of components, including, but not limited to, a processor 2004 and at least one communication chip 2006, each of which can be physically and electrically coupled to the motherboard 2002, or otherwise integrated therein. As will be appreciated, the motherboard 2002 may be, for example, any printed circuit board (PCB), whether a main board, a daughterboard mounted on a main board, or the only board of system 2000, etc.

Depending on its applications, computing system 2000 may include one or more other components that may or may not be physically and electrically coupled to the motherboard 2002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 2000 may include one or more integrated circuit structures or devices configured in accordance with an example embodiment (e.g., a module including an integrated circuit configured with a conductive via through a fin isolation structure, as variously provided herein). In some embodiments, multiple functions can be integrated into one or more chips (e.g., for instance, note that the communication chip 2006 can be part of or otherwise integrated into the processor 2004).

The communication chip 2006 enables wireless communications for the transfer of data to and from the computing system 2000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 2006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 2000 may include a plurality of communication chips 2006. For instance, a first communication chip 2006 may be dedicated to shorter range wireless communications such as Wi-Fi and Bluetooth and a second communication chip 2006 may be dedicated to longer range wireless communications such as GPS, EDGE, GPRS, CDMA, WiMAX, LTE, Ev-DO, and others.

The processor 2004 of the computing system 2000 includes an integrated circuit die packaged within the processor 2004. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 2006 also may include an integrated circuit die packaged within the communication chip 2006. In accordance with some such example embodiments, the integrated circuit die of the communication chip includes one or more semiconductor devices as variously described herein. As will be appreciated in light of this disclosure, note that multistandard wireless capability may be integrated directly into the processor 2004 (e.g., where functionality of any chips 2006 is integrated into processor 2004, rather than having separate communication chips). Further note that processor 2004 may be a chip set having such wireless capability. In short, any number of processor 2004 and/or communication chips 2006 can be used. Likewise, any one chip or chip set can have multiple functions integrated therein.

In various implementations, the computing system 2000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 2000 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.
Example 1 is an integrated circuit that includes a semiconductor region extending in a first direction from a first side of a source or drain region, a gate structure extending in a second direction over the semiconductor region, a dielectric layer beneath the gate structure, and a conductive via extending in the second direction adjacent to a second side of the source or drain region opposite from the first side and extending in a third direction below a top surface of the dielectric layer. The second direction is different than the first direction. The gate structure has a first width along the first direction at a top surface of the gate structure. The conductive via has a second width along the first direction at a top surface of the conductive via. The second width is greater than the first width.
Example 2 includes the integrated circuit of Example 1, further comprising a dielectric liner between the conductive via and the source or drain region.
Example 3 includes the integrated circuit of Example 2, wherein the dielectric liner has a thickness between about 5 nm and about 15 nm.
Example 4 includes the integrated circuit of any one of Examples 1-3, wherein the second width is at least twice as large as the first width.
Example 5 includes the integrated circuit of any one of Examples 1-4, wherein the semiconductor region comprises a plurality of semiconductor nanoribbons.
Example 6 includes the integrated circuit of Example 5, wherein the plurality of semiconductor nanoribbons comprise germanium, silicon, or a combination thereof.
Example 7 includes the integrated circuit of any one of Examples 1-6, wherein the conductive via comprises tungsten, cobalt, molybdenum, or ruthenium.
Example 8 includes the integrated circuit of any one of Examples 1-7, wherein the conductive via extends along the second direction between a first gate cut extending lengthwise along the first direction and a second gate cut extending lengthwise along the first direction, each of the first and second gate cuts comprising dielectric material.
Example 9 includes the integrated circuit of any one of Examples 1-8, wherein the semiconductor region is a first semiconductor region and the integrated circuit further comprises a second semiconductor region extending in the first direction from the second side of the source or drain region such that the second semiconductor region is between the source or drain region and the conductive via along the first direction.
Example 10 includes the integrated circuit of any one of Examples 1-9, further comprising a conductive contact that contacts a bottom surface of the conductive via.
Example 11 includes the integrated circuit of any one of Examples 1-10, wherein the first direction is orthogonal to the second direction, and the third direction is orthogonal to the first and second directions.
Example 12 includes the integrated circuit of any one of Examples 1-11, wherein the gate structure includes: a gate electrode; and gate dielectric layer between the gate electrode and the semiconductor region.
Example 13 includes the integrated circuit of Example 12, wherein the gate dielectric layer includes a high-k dielectric material.
Example 14 includes the integrated circuit of any one of Examples 1-13, further comprising a contact that contacts a top surface of the source or drain region.
Example 15 is a printed circuit board comprising the integrated circuit of any one of Examples 1-14.
Example 16 is an electronic device that includes a chip package having one or more dies. At least one of the one or more dies includes a first semiconductor region extending in a first direction from a first side of a source or drain region, a second semiconductor region extending in the first direction from a second side of the source or drain region, a gate structure extending in a second direction over the first semiconductor region with the second direction being different than the first direction, a dielectric layer beneath the gate electrode, and a conductive via extending in the second direction adjacent to the second semiconductor region and extending in a third direction below a top surface of the dielectric layer. The second semiconductor region is between the source or drain region and the conductive via along the first direction.
Example 17 includes the electronic device of Example 16, wherein the at least one of the one or more dies further comprises a dielectric liner between the conductive via and the source or drain region.
Example 18 includes the electronic device of Example 17, wherein the dielectric liner has a thickness between about 5 nm and about 15 nm.
Example 19 includes the electronic device of any one of Examples 16-18, wherein the gate structure has a first width along the first direction at a top surface of the gate structure and the conductive via has a second width along the first direction at a top surface of the conductive via, the second width being greater than the first width.
Example 20 includes the electronic device of Example 19, wherein the second width is at least twice as large as the first width.
Example 21 includes the electronic device of any one of Examples 16-20, wherein the first semiconductor region comprises a plurality of semiconductor nanoribbons.
Example 22 includes the electronic device of Example 21, wherein the plurality of semiconductor nanoribbons comprise germanium, silicon, or a combination thereof.
Example 23 includes the electronic device of any one of Examples 16-22, wherein the conductive via comprises tungsten, cobalt, molybdenum, or ruthenium.
Example 24 includes the electronic device of any one of Examples 16-23, wherein the conductive via extends along the second direction between a first gate cut extending lengthwise along the first direction and a second gate cut extending lengthwise along the first direction, each of the first and second gate cuts comprising dielectric material.
Example 25 includes the electronic device of any one of Examples 16-24, wherein the at least one of the one or more dies further comprises a conductive contact that contacts a bottom surface of the conductive via.
Example 26 includes the electronic device of any one of Examples 16-25, wherein the first direction is orthogonal to the second direction, and the third direction is orthogonal to the first and second directions.
Example 27 includes the electronic device of any one of Examples 16-26, further comprising a printed circuit board, wherein the chip package is coupled to the printed circuit board.
Example 28 is a method of forming an integrated circuit. The method includes forming a first fin having first semiconductor material extending in a first direction at a first length and a second fin having second semiconductor material extending colinearly with the first fin in the first direction at a second length longer than the first length with each of the first and second fins extending above a substrate; forming a source or drain region between the first fin and the second fin such that the source or drain region contacts ends of the first semiconductor material and ends of the second semiconductor material; forming a first gate structure extending over the first semiconductor material in a second direction different from the first direction; forming a second gate structure extending over the second semiconductor material in a second direction different from the first direction; forming a recess through at least an entire height of the second gate structure, and through the second semiconductor material; forming a dielectric liner on surfaces within the recess; and forming a conductive via within a remaining portion of the recess.
Example 29 includes the method of Example 28, wherein a top surface of the second gate structure is at least twice as long as a top surface of the first gate structure along the first direction.
Example 30 includes the method of Example 28 or 29, wherein forming the recess comprises forming the recess through at least an entire width of the second gate structure along the first direction.
Example 31 includes the method of any one of Examples 28-30, wherein forming the conductive via comprises forming a conductive material comprising tungsten, cobalt, molybdenum, or ruthenium.
Example 32 includes the method of any one of Examples 28-31, further including removing a portion of the dielectric liner along a bottom surface of the recess and removing a portion of the substrate beneath the recess.
Example 33 includes the method of any one of Examples 28-32, further including removing the substrate from a backside of the integrated circuit and forming a conductive contact on a bottom surface of the conductive via.
Example 34 is an integrated circuit that includes a semiconductor region extending in a first direction from a source or drain region, a gate structure extending in a second direction over the semiconductor region with the second direction being different than the first direction, a conductive via extending in the second direction adjacent to a second side of the source or drain region opposite from the first side and extending in a third direction below a bottom surface of the gate structure, a first dielectric gate cut extending lengthwise along the first direction, and a second dielectric gate cut extending lengthwise along the first direction. The conductive via extends along the second direction between the first dielectric gate cut and the second dielectric gate cut.
Example 35 includes the integrated circuit of Example 34, further comprising a dielectric liner between the conductive via and the source or drain region.
Example 36 includes the integrated circuit of Example 35, wherein the dielectric liner has a thickness between about 5 nm and about 15 nm.
Example 37 includes the integrated circuit of any one of Examples 34-36, wherein a top surface of the gate structure has a first width along the first direction and a top surface of the conductive via has a second width along the first direction, the second width being at least twice as large as the first width.
Example 38 includes the integrated circuit of any one of Examples 34-37, wherein the semiconductor region comprises a plurality of semiconductor nanoribbons.
Example 39 includes the integrated circuit of Example 38, wherein the plurality of semiconductor nanoribbons comprise germanium, silicon, or a combination thereof.
Example 40 includes the integrated circuit of any one of Examples 34-39, wherein the conductive via comprises tungsten, cobalt, molybdenum, or ruthenium.
Example 41 includes the integrated circuit of any one of Examples 34-40, wherein each of the first gate cut and second gate cut comprises silicon and nitrogen.
Example 42 includes the integrated circuit of any one of Examples 34-41, wherein the semiconductor region is a first semiconductor region and the integrated circuit further comprises a second semiconductor region extending in the first direction from the second side of the source or drain region such that the second semiconductor region is between the source or drain region and the conductive via along the first direction.
Example 43 includes the integrated circuit of any one of Examples 34-42, further comprising a conductive contact that contacts a bottom surface of the conductive via.
Example 44 includes the integrated circuit of any one of Examples 34-43, wherein the first direction is orthogonal to the second direction, and the third direction is orthogonal to the first and second directions.
Example 45 is a printed circuit board comprising the integrated circuit of any one of Examples 34-44.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor region extending in a first direction from a first side of a source or drain region;
a gate structure extending in a second direction over the semiconductor region, the second direction being different than the first direction, the gate structure having a first width along the first direction at a top surface of the gate structure;
a dielectric layer beneath the gate structure; and
a conductive via extending in the second direction adjacent to a second side of the source or drain region opposite from the first side and extending in a third direction below a top surface of the dielectric layer, the conductive via having a second width along the first direction at a top surface of the conductive via, the second width being greater than the first width.

2. The integrated circuit of claim 1, further comprising a dielectric liner between the conductive via and the source or drain region.

3. The integrated circuit of claim 2, wherein the dielectric liner has a thickness between about 5 nm and about 15 nm.

4. The integrated circuit of any one of claims 1 through 3, wherein the second width is at least twice as large as the first width.

5. The integrated circuit of any one of claims 1 through 4, wherein the semiconductor region comprises a plurality of semiconductor nanoribbons.

6. The integrated circuit of claim 5, wherein the plurality of semiconductor nanoribbons comprise germanium, silicon, or a combination thereof.

7. The integrated circuit of any one of claims 1 through 6, wherein the conductive via comprises tungsten, cobalt, molybdenum, or ruthenium.

8. The integrated circuit of any one of claims 1 through 7, wherein the conductive via extends along the second direction between a first gate cut extending lengthwise along the first direction and a second gate cut extending lengthwise along the first direction, each of the first and second gate cuts comprising dielectric material.

9. The integrated circuit of any one of claims 1 through 8, wherein the semiconductor region is a first semiconductor region and the integrated circuit further comprises a second semiconductor region extending in the first direction from the second side of the source or drain region such that the second semiconductor region is between the source or drain region and the conductive via along the first direction.

10. The integrated circuit of any one of claims 1 through 9, further comprising a conductive contact that contacts a bottom surface of the conductive via.

11. The integrated circuit of any one of claims 1 through 10, wherein the first direction is orthogonal to the second direction, and the third direction is orthogonal to the first and second directions.

12. The integrated circuit of any one of claims 1 through 11, wherein the gate structure includes: a gate electrode; and gate dielectric layer between the gate electrode and the semiconductor region.

13. The integrated circuit of claim 12, wherein the gate dielectric layer includes a high-k dielectric material.

14. The integrated circuit of any one of claims 1 through 13, further comprising a contact that contacts a top surface of the source or drain region.

15. A printed circuit board comprising the integrated circuit of any one of claims 1 through 14.
